# EUROPÄISCHE PATENTANMELDUNG

(11) **EP 4 000 806 A1**
(43) Veröffentlichungstag der Anmeldung: **25.05.2022**
(21) Anmeldenummer: 20207780.6
(22) Anmeldetag: 16.11.2020
(51) Int. Cl.: B24B 37/28, B24B 37/08, H01L 21/02, B24B 1/00, B24B 37/22

(54) **VERFAHREN ZUM BEIDSEITIGEN POLIEREN VON HALBLEITERSCHEIBEN ZWISCHEN EINEM UNTEREN POLIERTELLER UND EINEM OBEREN POLIERTELLER**

(71) Anmelder: Siltronic AG, 81677 München (DE)
(72) Erfinder: Dutschke, Vladimir, 09514 Lengefeld (DE); Gustke, Andreas, 01848 Hohnstein (DE); Ihle, Albrecht, 09599 Freiberg (DE)
(74) Vertreter: Staudacher, Wolfgang

(57) **Zusammenfassung**

Verfahren zum beidseitigen Polieren von Halbleiterscheiben zwischen einem unteren Polierteller und einem oberen Polierteller, umfassend
das Bekleben des unteren Poliertellers mit einem unteren Poliertuch;
das Pressen des unteren Poliertuchs gegen den unteren Polierteller;
das Ablegen eines Stapels auf das untere Poliertuch, wobei der Stapel einen Zwischenring und ein oberes Poliertuch umfasst und das obere Poliertuch mit einer zum oberen Polierteller weisenden klebenden Schicht versehen ist;
das Pressen des oberen Poliertellers gegen den Stapel und den unteren Polierteller, wobei wegen der Präsenz des Zwischenrings der Druck auf das obere Poliertuch in einem inneren Bereich mit einer ringförmigen Fläche, die sich von einem Innenrand des oberen Poliertuchs über eine Breite radial nach außen erstreckt, größer ist, als in einem angrenzenden äußeren Bereich;
das Entfernen des Zwischenrings;
das Pressen des oberen Poliertuchs gegen den oberen Polierteller im äußeren Bereich;
das Pressen der Poliertücher gegeneinander;
das Ablegen von Halbleiterscheiben auf dem unteren Polierteller; und das beidseitige Polieren der Halbleiterscheiben mit dem oberen Poliertuch und dem unteren Poliertuch in Gegenwart eines Poliermittels.

## Beschreibung

Gegenstand der Erfindung ist ein Verfahren zum beidseitigen Polieren von Halbleiterscheiben zwischen einem unteren Polierteller und einem oberen Polierteller.

### Stand der Technik / Probleme

Das beidseitige Polieren von Werkstücken wie Halbleiterscheiben wird auch Doppelseitenpolitur (DSP) genannt. Grundzüge der DSP von Halbleiterscheiben sind beispielsweise in US 2003/054650 A1 und in DE 100 07 390 A1 beschrieben.

In der Regel werden beide Polierteller einer DSP-Anlage mit Poliertüchern beklebt. Diese sollten blasenfrei aufgeklebt sein. Dabei ist es wichtig, dass das jeweilige Poliertuch auf dem Polierteller gleichmäßig stark haftet. Um die notwendige Haftung zu erreichen, können die Poliertücher zwischen den Poliertellern zusammengepresst werden (Tuchpressen). Durch das Pressen verfließt der Kleber und haftet besser. Verfahren zum Schaffen einer klebenden Verbindung zwischen dem jeweiligen Poliertuch und dem entsprechenden Polierteller sind aus US 2007 0 087 671 A1, JP 2006 289 523 A, JP 2006 346 808 A und DE 102 39 774 A1 bekannt.

In DE 10 2017 217 490 A1 wird empfohlen, während des Tuchpressens ein Zwischentuch zwischen dem unteren Poliertuch und dem oberen Poliertuch vorzusehen.

Die Erfinder der nachstehend beschriebenen Erfindung haben festgestellt, dass hinsichtlich des Schaffens der klebenden Verbindung noch Verbesserungsbedarf besteht.

Die Aufgabe der Erfindung wird gelöst durch ein Verfahren zum beidseitigen Polieren von Halbleiterscheiben zwischen einem unteren Polierteller und einem oberen Polierteller, umfassend
das Bekleben des unteren Poliertellers mit einem unteren Poliertuch;
das Pressen des unteren Poliertuchs gegen den unteren Polierteller;
das Ablegen eines Stapels auf das untere Poliertuch, wobei der Stapel einen Zwischenring und ein oberes Poliertuch umfasst und das obere Poliertuch mit einer zum oberen Polierteller weisenden klebenden Schicht versehen ist;
das Pressen des oberen Poliertellers gegen den Stapel und den unteren Polierteller, wobei wegen der Präsenz des Zwischenrings der Druck auf das obere Poliertuch in einem inneren Bereich mit einer ringförmigen Fläche, die sich von einem Innenrand des oberen Poliertuchs über eine Breite radial nach außen erstreckt, größer ist, als in einem angrenzenden äußeren Bereich;
das Entfernen des Zwischenrings;
das Pressen des oberen Poliertuchs gegen den oberen Polierteller im äußeren Bereich;
das Pressen der Poliertücher gegeneinander;
das Ablegen von Halbleiterscheiben auf dem unteren Polierteller; und das beidseitige Polieren der Halbleiterscheiben mit dem oberen Poliertuch und dem unteren Poliertuch in Gegenwart eines Poliermittels.

Das Verfahren ist hinsichtlich des Schaffens der klebenden Verbindung zwischen dem oberen Poliertuch und dem oberen Polierteller in zwei Abschnitte geteilt. Im ersten Abschnitt wird dafür gesorgt, dass zwischen dem oberen Poliertuch und dem oberen Polierteller eine klebende Verbindung geschaffen wird, bei der die Haftung in einem inneren Bereich des oberen Poliertuchs stärker ausgeprägt ist, als in einem angrenzenden äußeren Bereich. Im zweiten Abschnitt wird die Haftung im äußeren Bereich erhöht.

Die Poliertücher umfassen jeweils eine klebende Schicht. Zunächst wird das untere Poliertuch auf den unteren Polierteller geklebt. Danach wird das untere Poliertuch gegen den unteren Polierteller manuell oder durch eine Maschine gepresst. Gemäß einer Ausführungsform wird mindestens ein Werkzeug verwendet, um das untere Poliertuch gegen den unteren Polierteller zu pressen. Das Werkzeug ist vorzugsweise eine Rakel. Die Werkzeugbewegung erfolgt vorzugsweise radial, so dass Blasen vorzugsweise am äußeren Rand des unteren Poliertuchs aus dem Zwischenraum zwischen dem unteren Polierteller und der klebenden Schicht gedrückt werden.

Danach wird ein Zwischenring auf das untere Poliertuch gelegt. Der Zwischenring hat einen Innendurchmesser, der im Wesentlichen dem Innendurchmesser des unteren Poliertuchs entspricht. Die Breite des Zwischenrings beträgt vorzugsweise nicht weniger als 30 mm und nicht mehr als 100 mm. Der Zwischenring besteht vorzugsweise aus Kunststoff, beispielsweise aus Polyethylen und hat eine Dicke von vorzugsweise nicht weniger als 100 µm und nicht mehr als 1000 µm. Auf den Zwischenring und der nicht vom Zwischenring abgedeckten Fläche des unteren Poliertuchs wird das obere Poliertuch gelegt. Die klebende Schicht des oberen Poliertuchs weist dabei nach oben. Der Zwischenring und das obere Poliertuch bilden einen Stapel, der auf dem unteren Poliertuch liegt. Dann wird der obere Polierteller gegen den Stapel und den unteren Polierteller gepresst und dieser Zustand eine gewisse Zeit aufrechterhalten. Durch die Anwesenheit des Zwischenrings wird das obere Poliertuch im Bereich des Zwischenrings mit höherem Druck gegen den oberen Polierteller gedrückt, als im angrenzenden äußeren Bereich. Auf diese Weise entsteht ein innerer Bereich, in dem das obere Poliertuch vergleichsweise stark und blasenfrei am oberen Polierteller haftet.

Gemäß einer Ausgestaltung der Erfindung ist auch ein Zwischentuch im Stapel. In diesem Fall befindet sich der Zwischenring unter oder vorzugsweise über dem Zwischentuch. Das Zwischentuch hat eine radiale Breite, die im Wesentlichen derjenigen der Poliertücher entspricht, und vorzugsweise die in DE 10 2017 217 490 A1 beschriebenen Eigenschaften, also insbesondere eine Kompressibilität bei Raumtemperatur von mindestens 3 %, vorzugsweise 3 % bis 10 %.

Nach dem Pressen des oberen Poliertellers gegen den Stapel und den unteren Polierteller werden der Zwischenring und im Falle von dessen Verwendung auch das Zwischentuch entfernt. Hierzu werden die Polierteller auseinandergefahren.

Im Anschluss daran wird das obere Poliertuch mit Hilfe eines Werkzeugs gegen den oberen Polierteller manuell oder durch eine Maschine gepresst, vorzugsweise nur im äußeren Bereich. Das Werkzeug ist vorzugsweise eine Rakel. Die Werkzeugbewegung erfolgt vorzugsweise radial oder in Umfangsrichtung. Gasblasen, die gegebenenfalls zwischen der klebenden Schicht des oberen Poliertuchs und dem oberen Polierteller gefangen sind, werden am Außenumfang des oberen Poliertuchs freigesetzt.

Danach wird ein Tuchpressen vorgenommen, im Zuge dessen der obere Polierteller über einen längeren Zeitraum gegen den unteren Polierteller mit vergleichsweise hohem Druck gepresst wird. Dabei werden die Poliertücher gegeneinander gepresst, wobei das Zwischentuch erneut oder erstmalig zwischen die Poliertücher gelegt sein kann.

Gemäß einer Ausgestaltung der Erfindung haben die Polierteller zu Beginn des Tuchpressens eine Temperatur von 40 °C bis 50 °C, um die Viskosität des Klebers der klebenden Schicht zu verringern, gemäß einer anderen Ausgestaltung Raumtemperatur (23 °C ± 2 °C).

Nach dem blasenfreien Anbringen der Poliertücher und gegebenenfalls nach einem Abrichten (Dressing) der Poliertücher wird das erfindungsgemäße Verfahren mit dem beidseitigen Polieren von Halbleiterscheiben in Gegenwart eines Poliermittels fortgesetzt. Vorzugsweise erfolgt die DSP mit Prozessparametern, die bereits in DE 10 2017 217 490 A1 empfohlen sind. Einige davon seien nachfolgend nochmals genannt.

Bevorzugt ist die Verwendung von Poliertüchern, die eine geringe oder sehr geringe Kompressibilität aufweisen. Bevorzugt beträgt die Kompressibilität des jeweiligen Poliertuches nicht mehr als 2,5%, besonders bevorzugt nicht mehr als 2,0%, ermittelt bei Raumtemperatur (23 °C ± 2 °C). Die Bestimmung der Kompressibilität erfolgt analog zur JIS-L-1096 (Testing Methods for Woven Fabrics).

Die Dicke der Poliertücher beträgt vorzugsweise nicht weniger als 0,7 und nicht mehr als 1,5 mm.

Zum Polieren werden die Halbleiterscheiben jeweils in eine entsprechend deren Umfang dimensionierte Aussparung einer Läuferscheibe gelegt. Die Halbleiterscheiben bestehen vorzugsweise aus einkristallinem Silizium und haben vorzugsweise einen Durchmesser von nicht weniger als 200 mm, besonders bevorzugt einen Durchmesser von mindestens 300 mm.

Das Poliermittel ist zweckmäßigerweise eine Suspension, die vorzugsweise kolloiddisperse Kieselsäure und gegebenenfalls weitere Verbindungen, beispielsweise solche, die den pH-Wert einstellen, enthält.

Der Materialabtrag durch DSP beträgt vorzugsweise nicht mehr als 15 µm, besonders bevorzugt 5 µm bis 12 µm je polierter Seitenfläche.

Einzelheiten zur Erfindung werden nachfolgend unter Bezugnahme auf Zeichnungen erläutert.

### Kurzbeschreibung der Figuren

**Fig. 1** zeigt in perspektivischer Darstellung typische Merkmale einer DSP-Maschine.
**Fig. 2** zeigt eine Draufsicht auf den unteren Polierteller.
**Fig. 3** zeigt in Schnittdarstellung eine Ausführungsform des erfindungsgemäßen Stapels.
**Fig. 4** zeigt in Schnittdarstellung eine weitere Ausführungsform des erfindungsgemäßen Stapels.

### Liste der verwendeten Bezugszeichen

- **1**: Stapel
- **2**: Zwischenring
- **3**: innerer Bereich
- **4**: äußerer Bereich
- **5**: innerer Rand
- **6**: äußerer Rand
- **7**: Zwischentuch
- **8**: klebende Schicht
- **9**: Achse
- **10**: Achse
- **11**: Achse
- **12**: unterer Polierteller
- **13**: oberer Polierteller
- **14**: Halbleiterscheibe
- **15**: Läuferscheibe
- **16**: oberes Poliertuch
- **17**: Arbeitsspalt
- **18**: Kanal
- **19**: unteres Poliertuch
- **20**: äußerer Stiftkranz
- **21**: innerer Stiftkranz
- **22**: Sensor
- **23**: Sensor
- **24**: Scheibenaufnahme
- **nₒ**: Drehzahl des oberen Poliertellers
- **nᵤ**: Drehzahl des unteren Poliertellers
- **nᵢ**: Drehzahl des inneren Stiftkranzes
- **nₐ**: Drehzahl des äußeren Stiftkranzes

### Detaillierte Beschreibung erfindungsgemäßer Ausführungsbeispiele

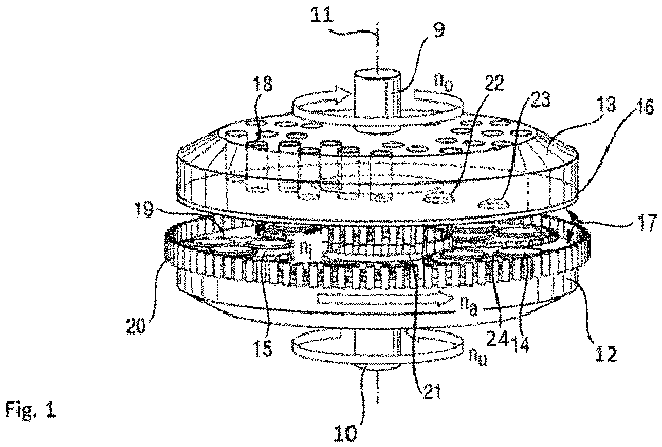

Fig. 1 zeigt den prinzipiellen Aufbau einer DSP-Maschine: Ein unterer, ringförmiger Polierteller 12 und ein oberer Polierteller 13 rotieren auf kollinearen Achsen 9 und 10 mit Umdrehungsgeschwindigkeiten nₒ und nᵤ. Innerhalb des Innendurchmessers der Polierteller 13 und 12 sind ein innerer Stiftkranz 21 und außerhalb des Außendurchmessers der ringförmigen Polierteller 12 und 13 ein äußerer Stiftkranz 20 angeordnet, die mit Umdrehungsgeschwindigkeiten nᵢ und nₐ kollinear zu den Poliertellern und somit um die gemeinsame Achse 11 der DSP-Maschine rotieren. Der innere Stiftkranz 21 und der äußere Stiftkranz 20 bilden eine Abwälzvorrichtung, in die beispielsweise drei oder fünf Läuferscheiben 15 mit einer passenden Außenverzahnung eingelegt sind. Die Läuferscheiben 15 weisen jeweils mindestens eine oder mehrere Scheibenaufnahmen 24 für Halbleiterscheiben 14 auf.

Der untere Polierteller 12 und der obere Polierteller 13 tragen auf ihren einander zugewandten Oberflächen ein unteres Poliertuch 19 beziehungsweise ein oberes Poliertuch 16. Die einander zugewandten Oberflächen des unteren und oberen Poliertuchs 19 und 16 bilden untere beziehungsweise obere Arbeitsflächen. Diese gelangen während der Bearbeitung in Kontakt mit Vorder- und Rückseite der Halbleiterscheiben 14.

Mittels der Abwälzvorrichtung und der Außenverzahnung werden die Läuferscheiben 15 mit den Halbleiterscheiben 14 auf zykloidischen Bahnen gleichzeitig über die untere und obere Arbeitsfläche geführt, wobei die Läuferscheiben 15 auf Planetenbahnen um die Achse 11 umlaufen. Der zwischen den Arbeitsflächen gebildete Raum, in dem sich die Läuferscheiben 15 bewegen, wird als Arbeitsspalt 17 bezeichnet. Während der Bearbeitung übt der obere Polierteller 13 eine Kraft auf den unteren Polierteller 12 aus, und es wird über Kanäle 18 im oberen Polierteller 13 ein Poliermittel zugeführt. Die DSP-Maschine kann Sensoren 22 und 23 aufweisen, die an unterschiedlichen Radialpositionen beispielsweise im oberen Polierteller 13 angeordnet sind und die während des Polierens von Halbleiterscheiben 14 den Abstand der einander zugewandten Oberflächen der Polierteller 12 und 13 messen.

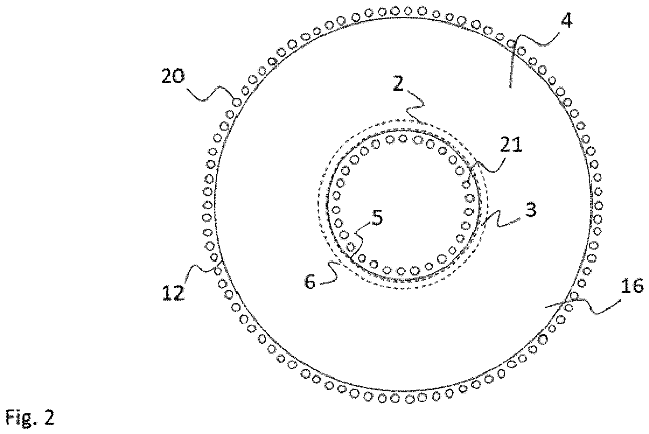

Fig. 2 zeigt eine Draufsicht auf den unteren Polierteller 12 zu einem Zeitpunkt, wenn der Stapel 1 auf dem unteren Polierteller abgelegt worden ist. Auf dem unteren Poliertuch liegt ein Zwischenring 2, der sich vom inneren Rand 5 der Poliertücher bis zu einem äußeren Rand 6 nach außen erstreckt. Darüber liegt das obere Poliertuch 16 mit nach oben weisender klebender Schicht. Der Zwischenring 2 grenzt von der Fläche des oberen Poliertuchs 16 einen inneren Bereich 3 und einen äußeren Bereich 4 ab. Der äußere Bereich 4 erstreckt sich vom Rand 6 des Zwischenrings 2 bis zum äußeren Rand des oberen Poliertuchs 16.

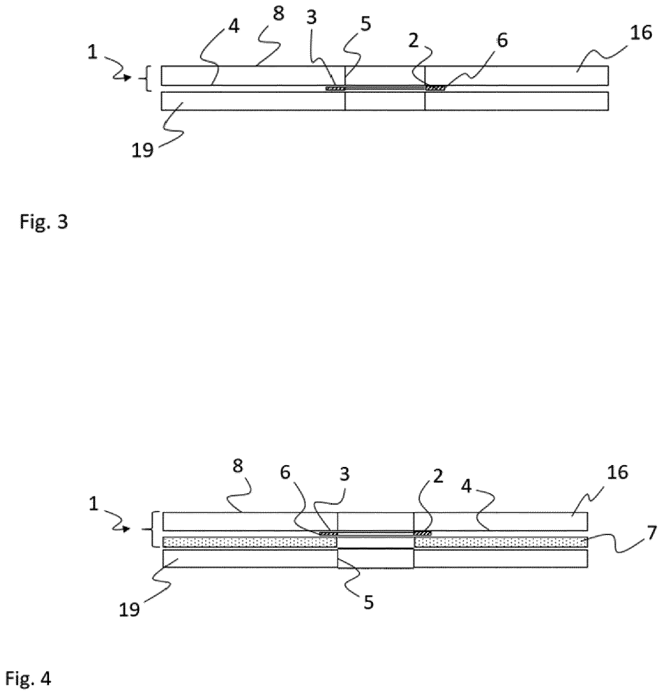

Fig. 3 zeigt in Schnittdarstellung den Stapel 1 gemäß Fig. 2 während des Pressens des oberen Poliertellers 13 gegen den Stapel 1 und den unteren Polierteller 12. Der Druck auf die Poliertücher ist wegen der Anwesenheit des Zwischenrings 2 im inneren Bereich 3 größer, als im äußeren Bereich 4. Die klebende Schicht 8 des oberen Poliertuchs, die dem oberen Polierteller zugewandt ist, haftet deshalb im inneren Bereich 3 stärker, als im äußeren Bereich 4.

Entsprechend der Ausführungsform gemäß Fig.4 umfasst der Stapel 1 neben dem oberen Poliertuch 16 und dem Zwischenring 2 auch ein Zwischentuch 7, das das Schaffen der klebenden Verbindung zwischen den Poliertüchern und den entsprechenden Poliertellern begünstigt. Das Zwischentuch 7 bedeckt den inneren Bereich 3 und den äußeren Bereich 4.

## Patentansprüche

1. Verfahren zum beidseitigen Polieren von Halbleiterscheiben zwischen einem unteren Polierteller und einem oberen Polierteller, umfassend
das Bekleben des unteren Poliertellers mit einem unteren Poliertuch;
das Pressen des unteren Poliertuchs gegen den unteren Polierteller;
das Ablegen eines Stapels auf das untere Poliertuch, wobei der Stapel einen Zwischenring und ein oberes Poliertuch umfasst und das obere Poliertuch mit einer zum oberen Polierteller weisenden klebenden Schicht versehen ist;
das Pressen des oberen Poliertellers gegen den Stapel und den unteren Polierteller, wobei wegen der Präsenz des Zwischenrings der Druck auf das obere Poliertuch in einem inneren Bereich mit einer ringförmigen Fläche, die sich von einem Innenrand des oberen Poliertuchs über eine Breite radial nach außen erstreckt, größer ist, als in einem angrenzenden äußeren Bereich;
das Entfernen des Zwischenrings;
das Pressen des oberen Poliertuchs gegen den oberen Polierteller im äußeren Bereich;
das Pressen der Poliertücher gegeneinander;
das Ablegen von Halbleiterscheiben auf dem unteren Polierteller; und
das beidseitige Polieren der Halbleiterscheiben mit dem oberen Poliertuch und dem unteren Poliertuch in Gegenwart eines Poliermittels.

2. Verfahren nach Anspruch 1, **gekennzeichnet durch**
das Legen eines Zwischentuchs in den Stapel, das den inneren und den äußeren Bereich überdeckt und über oder unter dem Zwischenring angeordnet ist.

3. Verfahren nach Anspruch 1 oder Anspruch 2, **dadurch gekennzeichnet, dass** die Poliertücher mittels mindestens eines Werkzeugs gegen die Polierteller gepresst werden.

4. Verfahren nach einem der Ansprüche 1 bis 3, **gekennzeichnet durch**
das Pressen der Poliertücher gegeneinander in Gegenwart eines Zwischentuchs.
